# EUROPEAN PATENT APPLICATION

(11) **EP 4 773 328 A1**
(43) Date of publication of application: **08.07.2026**
(21) Application number: 24905675.5
(22) Date of filing: 09.09.2024
(51) Int. Cl.: H01M 10/42, G01R 31/3842, G01R 31/396

(54) **METHOD AND SYSTEM FOR TRIGGERING THERMAL RUNAWAY OF BATTERY**

(30) Priority: 19.12.2023 CN 202311755533
(71) Applicant: Contemporary Amperex Technology Co., Limited, Ningde, Fujian 352100 (CN)
(72) Inventor: GONG, Pingyun, Ningde, Fujian 352100 (CN)
(74) Representative: Kraus & Lederer PartGmbB
(86) International application number: PCT/CN2024/117809
(87) International publication number: WO 2025/130183

(57) **Abstract**

A method and system for triggering battery thermal runaway, which can trigger thermal runaway of a battery cell during a battery testing process. The method includes: charging a target battery cell in a battery, such that an energy level of the target battery cell is greater than an energy level of the other battery cells in the battery; and charging the battery in a case where the energy level of the target battery cell is greater than the energy level of the other battery cells.

## Description

### CROSS-REFERENCE TO RELATED APPLICATIONS

The present application claims priority to Chinese Patent Application No. 202311755533.6, titled "METHOD AND SYSTEM FOR TRIGGERING BATTERY THERMAL RUNAWAY," filed on December 19, 2023, the entire content of which is incorporated herein by reference.

### TECHNICAL FIELD

The present application relates to the field of batteries, and in particular, to a method and system for triggering battery thermal runaway.

### BACKGROUND

As an energy storage apparatus, batteries are widely used in many fields such as electronic products, electric vehicles, and energy storage power stations. Whether the safety of batteries meets usage requirements is a subject of extensive current research. Thermal runaway of batteries is one of the safety issues of batteries. When thermal runaway occurs in a battery, the temperature inside the battery rises, which may trigger a chain reaction of thermal runaway, causing fire, explosion, or the like of the battery. Meanwhile, the process of thermal runaway of a battery may cause the propagation of thermal runaway. Accidents caused by thermal runaway and its propagation are highly likely to cause casualties and property losses.

Typically, it is necessary to trigger thermal runaway of a certain battery cell to test the propagation of thermal runaway in the battery when that battery cell undergoes thermal runaway, thereby analyzing the safety of the battery. Therefore, how to trigger thermal runaway of a battery cell has become a problem urgently requiring a solution.

### SUMMARY OF THE INVENTION

Embodiments of the present application provide a method and system for triggering battery thermal runaway, which can trigger thermal runaway of a battery cell during a battery testing process.

In a first aspect, a method for triggering battery thermal runaway is provided. The method includes: charging a target battery cell in a battery, such that an energy level of the target battery cell is greater than an energy level of the other battery cells in the battery; and charging the battery in a case where the energy level of the target battery cell is greater than the energy level of the other battery cells.

Herein, the energy level may be any one of state of charge (SOC), state of energy (SOE), and capacity.

In the embodiments of the present application, the target battery cell is charged until its energy level is higher than the energy level of the other battery cells in the battery, by creating an energy level imbalance between the target battery cell and the other battery cells, during charging of the battery as a whole, before the other batteries reach a charging cutoff voltage, the target battery cell can undergo thermal runaway due to overcharging, while the other battery cells operate within a normal energy level range. With this method, firstly, there is no need to prepare special battery cells or batteries during the production process, nor is there a need for complex modification of the battery, making the testing process unrestricted by time and space, and enabling widespread application in sampling tests of batteries; secondly, the structure of the battery is not destroyed, reducing the impact on the airtightness and high-voltage electrical connection of the battery; finally, the thermal runaway behavior during a dynamic charging process can be simulated.

In some possible implementations, before the charging the target battery cell in the battery, the method further includes: adjusting an energy level of the battery to a preset energy level, the preset energy level being less than an energy level of the battery in a fully charged state. In this way, the consistency of initial states of the battery cells in the battery can be maintained.

In some possible implementations, the preset energy level is less than or equal to 85% of the energy level in the fully charged state. For example, the preset energy level is 50%, 60%, 70%, or 80% of the energy level in the fully charged state, thereby reducing the risk of overcharging of the target battery cell during charging of the target battery cell.

In some possible implementations, before the adjusting the energy level of the battery to the preset energy level, the method further includes: charging the battery to the fully charged state, and where the adjusting the energy level of the battery to the preset energy level includes: discharging the energy level of the battery from the energy level in the fully charged state to the preset energy level. In other words, the battery can first be charged to the fully charged state and then discharged until its energy level is the preset energy level, so as to achieve adjustment of the energy level of the battery in the initial state.

In some possible implementations, the charging the target battery cell in the battery, such that the energy level of the target battery cell is greater than the energy level of the other battery cells in the battery includes: charging the target battery cell, such that the energy level of the target battery cell exceeds the energy level of the other battery cells by an amount greater than or equal to 15% of the energy level in the fully charged state, and less than or equal to 70% of the energy level in the fully charged state. For example, the amount by which the energy level of the target battery cell exceeds the energy level of the other battery cells is 20%, 30%, 40%, or 50% of the energy level in the fully charged state. In this way, the risk of overcharging of the target battery cell can be reduced during charging the target battery cell, and the occurrence of thermal runaway in the target battery cell is facilitated during charging of the battery as a whole, thereby achieving effective testing of the battery.

In some possible implementations, the target battery cell is accommodated within a box body, the box body including a first box body portion and a second box body portion interlocked together, with electrode terminals of the target battery cell facing the first box body portion, where during charging of the target battery cell, the first box body portion is in a removed state, so as to enable electrical connection between the electrode terminals and a charging and discharging apparatus; and where the charging the target battery cell in the battery includes: controlling the charging and discharging apparatus to charge the target battery cell.

Since it is only necessary to open the first box body portion of the box body and connect leads of the charging and discharging apparatus to the electrode terminals of the target battery cell, after the charging and discharging apparatus completes charging the target battery cell, the connection between the target battery cell and the charging and discharging apparatus can be disconnected, and the first box body portion can be re-covered onto the second box body portion, such that the state of the battery is the same as its state in practical application. During this process, the structure of the battery is not destroyed, and neither the airtightness of the battery nor high-voltage connectors is affected.

In some possible implementations, an end portion of a positive electrode lead of the charging and discharging apparatus is adhered to a positive electrode terminal of the target battery cell, and an end portion of a negative electrode lead of the charging and discharging apparatus is adhered to a negative electrode terminal of the target battery cell. This connection method can save costs.

In some possible implementations, an end portion of a positive electrode lead of the charging and discharging apparatus is pressed into contact with a positive electrode terminal of the target battery cell by a push-pressing mechanism, and an end portion of a negative electrode lead of the charging and discharging apparatus is pressed into contact with a negative electrode terminal of the target battery cell by the push-pressing mechanism. Since the push-pressing mechanism is used to directly press the end portions of the leads and the electrode terminals of the target battery cell together, the reliability of contact between the leads and the electrode terminals is improved, thereby reducing the probability of poor contact occurring between the leads and the electrode terminals during the testing process.

In some possible implementations, before the charging the target battery cell in the battery, the method further includes: disabling a balancing function of a battery management system of the battery.

The balancing function of the battery is to adjust a voltage difference between battery cells or a voltage difference between battery cell groups to be within a suitable range, thereby causing each battery cell to maintain a substantially identical state during use and reducing the risk of overcharging or overdischarging. Since the embodiments of the present application require triggering occurrence of thermal runaway in the target battery cell due to overcharging, disabling the balancing function of the battery management system can reduce the risk of inability to trigger occurrence of thermal runaway in the target battery cell due to an energy level difference between the target battery cell and the other battery cells being balanced, thereby reducing an impact of the balancing function on the testing process.

In some possible implementations, before the charging the battery, the method further includes: disabling an overvoltage protection function of the battery management system of the battery.

Since an excessively high voltage may cause damage to the battery, the overvoltage protection function of the battery can reduce the probability of occurrence of abnormal voltage or excessively high voltage during charging and discharging of the battery. For example, upon detecting that a voltage of the battery exceeds a rated voltage, a charging and discharging circuit can be cut off to prevent the voltage from continuing to rise. Since the embodiments of the present application require triggering occurrence of thermal runaway in the target battery cell due to overcharging, it is necessary to disable the overvoltage protection function, in order to reduce the risk of termination of the testing process due to the charging circuit being cut off before the target battery cell undergoes thermal runaway, thereby reducing the impact of the overvoltage protection function on the testing process.

In some possible implementations, the thermal runaway condition includes at least one of the following conditions: a voltage of the battery, a temperature rise rate of the battery, and state information of the battery satisfying the thermal runaway condition; a temperature of the battery reaching a temperature threshold; a charging time of the battery reaching a time threshold; or a voltage of the battery reaching a voltage threshold. For example, the time threshold is greater than or equal to 4 hours, and/or the temperature threshold is greater than or equal to 300 °C, and/or the voltage threshold is greater than or equal to 1.1 times or 1.2 times a charging cutoff voltage of the battery. By reasonably setting the thermal runaway condition, and setting test termination conditions such as charging time, battery temperature, and voltage, the testing process can be effectively controlled without affecting the test effects.

In some possible implementations, the thermal runaway condition includes: the voltage of the battery being greater than or equal to 1 V and a temperature rise rate of the battery over three consecutive samplings being greater than or equal to 3 °C/s, or state information of the battery including fire or explosion; or a voltage drop of the battery exceeding 25% of an initial voltage or the temperature of the battery exceeding the temperature threshold, and a temperature rise rate of the battery being greater than or equal to 1 °C/s. Adopting the thermal runaway condition from relevant standards to determine whether thermal runaway occurs in the battery facilitates combining the testing solution of the embodiments of the present application with existing standards, and facilitates promotion of this testing solution.

In some possible implementations, the target battery cell includes one or more battery cells, the plurality of battery cells being connected in parallel and/or in series, so as to adapt to various testing requirements.

In some possible implementations, the battery includes a battery box or a battery cluster.

For example, the battery is a battery box, and the target battery cell is located at a central portion of the battery box.

As another example, the battery is a battery cluster, the battery cluster including a plurality of battery boxes, where a battery box in which the target battery cell is located among the plurality of battery boxes is located at a central portion of the battery cluster, the target battery cell being located at a central portion of the battery box in which it is located.

Selecting a battery box located at a central portion in the battery cluster, and/or selecting a battery cell at a central portion of the battery box as the target battery cell, can make the propagation of thermal runaway more uniform, thereby making the test results more comprehensive and stable.

In some possible implementations, the charging the battery includes: performing constant-current charging or constant-power charging on the battery. Here, if the battery is intended for application in a power system, constant-current charging may be performed on the battery. For example, a current used in the constant-current charging is greater than or equal to 1 C, or is equal to a maximum allowable current of the battery. If the battery is intended for application in an energy storage system, constant-power charging may be performed on the battery, thereby adapting to the application of the battery in different scenarios.

In some possible implementations, the method further includes: monitoring, during charging of the battery, at least one of the following information of the battery and a monitoring object arranged adjacent to the battery: charging time, voltage, temperature, temperature rise rate, or state information. The state information includes, for example, at least one of the following: swelling, electrolyte leakage, smoking, fire, explosion, and a position of case rupture.

During charging of the battery, the charging time, voltage, current, temperature, and temperature rise rate of the battery are recorded; the voltage, current, temperature, and temperature rise rate of a monitoring object arranged adjacent to the battery are recorded; and test phenomena including swelling, electrolyte leakage, smoking, fire, explosion, a position of box body rupture, or the like, are recorded. By recording the aforementioned information of the battery during the charging process as well as the delay phenomena, whether thermal runaway of the battery is triggered can be timely determined.

In some possible implementations, the method further includes: testing insulation performance of the battery.

The insulation performance of the battery can reduce the risk of electrical leakage in the high-voltage circuit; when phenomena such as swelling, electrolyte leakage, smoking, fire, explosion, and box body rupture occur in the battery, the insulation performance of the battery is likely already compromised. However, after thermal runaway of the target battery cell is triggered or the test is terminated, and no obvious thermal runaway phenomenon is observed in the battery itself or its nearby monitoring, by testing the insulation performance of the battery, a better understanding of the risks caused by battery thermal runaway can be provided, making the battery testing more comprehensive and reliable.

In a second aspect, a system for triggering battery thermal runaway is provided, the system including a battery, a charging and discharging module, and a control module. The battery includes a target battery cell, where the control module is configured to: control the charging and discharging module to charge the target battery cell, such that an energy level of the target battery cell is greater than an energy level of the other battery cells in the battery; and control the charging and discharging module to charge the battery in a case where the energy level of the target battery cell is greater than the energy level of the other battery cells.

Herein, the energy level may be any one of state of charge (SOC), state of energy (SOE), and capacity.

In some possible implementations, the charging and discharging module includes a first charging and discharging apparatus and a second charging and discharging apparatus, where the first charging and discharging apparatus is configured to charge and discharge the target battery cell, and the second charging and discharging apparatus is configured to charge and discharge the battery.

In some possible implementations, the target battery cell is accommodated within a box body, the box body including a first box body portion and a second box body portion interlocked together, with electrode terminals of the target battery cell facing the first box body portion, where during charging of the target battery cell by the first charging and discharging apparatus, the first box body portion is in a removed state, so as to enable connection between the electrode terminals and the first charging and discharging apparatus.

In some possible implementations, an end portion of a positive electrode lead of the first charging and discharging apparatus is adhered to a positive electrode terminal of the target battery cell, and an end portion of a negative electrode lead of the first charging and discharging apparatus is adhered to a negative electrode terminal of the target battery cell.

In some possible implementations, an end portion of a positive electrode lead of the first charging and discharging apparatus is pressed into contact with a positive electrode terminal of the target battery cell by a push-pressing mechanism, and an end portion of a negative electrode lead of the first charging and discharging apparatus is pressed into contact with a negative electrode terminal of the target battery cell by the push-pressing mechanism.

In some possible implementations, the charging and discharging module is further configured to: before charging the target battery cell in the battery, adjust an energy level of the battery to a preset energy level, the preset energy level being less than an energy level of the battery in a fully charged state.

In some possible implementations, the preset energy level is less than or equal to 85% of the energy level in the fully charged state. For example, the preset energy level is 50%, 60%, 70%, or 80% of the energy level in the fully charged state.

In some possible implementations, the charging and discharging module is specifically configured to: before adjusting the energy level of the battery to the preset energy level, charge the battery to the fully charged state; and discharge the energy level of the battery from the energy level in the fully charged state to the preset energy level.

In some possible implementations, the charging and discharging module is specifically configured to: charge the target battery cell, such that the energy level of the target battery cell exceeds the energy level of the other battery cells by an amount greater than or equal to 20% of the energy level in the fully charged state, and less than or equal to 50% of the energy level in the fully charged state. For example, the amount by which the energy level of the target battery cell exceeds the energy level of the other battery cells is 20%, 30%, 40%, or 50% of the energy level in the fully charged state.

In some possible implementations, the control module is further configured to: before charging the target battery cell in the battery, disable a balancing function of a battery management system of the battery.

In some possible implementations, the control module is further configured to: before charging the battery, disable an overvoltage protection function of the battery management system of the battery.

In some possible implementations, the control module is further configured to control the charging and discharging module to terminate charging the battery in a case where at least one of the following conditions is satisfied: the battery satisfying a thermal runaway condition; a temperature of the battery reaching a temperature threshold; a charging time of the battery reaching a time threshold; or a voltage of the battery reaching a voltage threshold.

In some possible implementations, the thermal runaway condition includes: the voltage of the battery being greater than or equal to 1 V and a temperature rise rate of the battery over three consecutive samplings being greater than or equal to 3 °C/s, or state information of the battery including fire or explosion; or a voltage drop of the battery exceeding 25% of an initial voltage or the temperature of the battery exceeding the temperature threshold, and a temperature rise rate of the battery being greater than or equal to 1 °C/s.

In some possible implementations, the time threshold is greater than or equal to 4 hours, and/or the temperature threshold is greater than or equal to 300 °C, and/or the voltage threshold is greater than or equal to 1.1 times or 1.2 times a charging cutoff voltage of the battery.

In some possible implementations, the target battery cell includes one or more battery cells, the plurality of battery cells being connected in parallel and/or in series.

In some possible implementations, the battery includes a battery box or a battery cluster.

In some possible implementations, the battery is a battery box, and the target battery cell is located at a central portion of the battery box.

In some possible implementations, the battery is a battery cluster, the battery cluster including a plurality of battery boxes, where a battery box in which the target battery cell is located among the plurality of battery boxes is located at a central portion of the battery cluster, the target battery cell being located at a central portion of the battery box in which it is located.

In some possible implementations, the charging and discharging module is specifically configured to perform constant-current charging or constant-power charging on the battery. A current of the constant-current charging may be, for example, greater than or equal to 1 C, or may be a maximum allowable current of the battery.

In some possible implementations, the control module is further configured to monitor, during charging of the battery by the charging and discharging module, at least one of the following information of the battery and a monitoring object arranged adjacent to the battery: charging time, voltage, temperature, temperature rise rate, or state information. The state information includes, for example, at least one of the following: swelling, electrolyte leakage, smoking, fire, explosion, and a position of box body rupture.

In some possible implementations, the system further includes an insulation monitoring module, and the control module is further configured to control the insulation monitoring module to test insulation performance of the battery.

### BRIEF DESCRIPTION OF THE DRAWINGS

In order to explain technical solutions of the examples of the present application more clearly, a brief introduction of drawings to be used in the examples of the present application will be made below. Apparently, the drawings described below are merely some examples of the present application, and other drawings can be obtained according to these drawings by those ordinarily skilled in the art without creative efforts.
FIG. 1 is a schematic flowchart of a method for triggering battery thermal runaway according to an embodiment of the present application.
FIG. 2 is a possible schematic block diagram of a battery according to an embodiment of the present application.
FIG. 3 is another possible schematic block diagram of a battery according to an embodiment of the present application.
FIG. 4 is a schematic block diagram of a system for triggering battery thermal runaway according to an embodiment of the present application.
FIG. 5 is a schematic diagram of a box body of a battery box according to an embodiment of the present application.
FIG. 6 is a schematic diagram of voltage and temperature variations with SOC during thermal runaway according to an embodiment of the present application.
FIG. 7 is a schematic diagram of voltage and temperature variations with time during thermal runaway according to an embodiment of the present application.
FIG. 8 is a schematic diagram of a possible specific testing process of the method shown in FIG. 1.

### DETAILED DESCRIPTION

The implementations of the present application are further described in detail below with reference to the accompanying drawings and embodiments. The embodiments of the present application are described in further detail below in conjunction with the accompanying drawings and embodiments.

Unless otherwise defined, all technical and scientific terms used in the present application have the same meanings as those commonly understood by those skilled in the art to which the present application belongs. The terms used in the specification of the present application are merely for the purpose of describing specific embodiments, but are not intended to limit the present application. The terms "include" and "have" and any variations thereof in the specification and the claims of the present application as well as the above description of the drawings are intended to cover non-exclusive inclusions. The terms "first," "second," etc. in the specification and the claims of the present application as well as the above drawings are used to distinguish different objects, rather than to describe a specific order or primary-secondary relationship. "Perpendicular" does not mean being perpendicular in the strict sense, but is within the margin of error allowed. "Parallel" is not strictly parallel, but within an allowable range of an error.

Reference in the present application to an "embodiment" means that a particular feature, structure, or characteristic described in connection with the embodiment can be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described in the present application may be combined with other embodiments.

In the description of the present application, it should be noted that the terms "mounting," "connecting," "connection" and "attachment" should be understood in a broad sense, unless otherwise explicitly specified or defined, for example, it may be a fixed connection, a detachable connection or an integrated connection; and may be a direct connection or an indirect connection through an intermediate medium, or may be a communication between the interior of two elements. For those of ordinary skill in the art, the specific meanings of the above terms in the present application can be understood according to specific situations.

In the present application, the term "and/or" is merely an association that describes the associated object, indicating that there can be three kinds of relationships, for example, A and/or B may denote the following three situations: A exists alone, A and B exist at the same time, and B exists alone. In addition, the character "/" in the present application generally means that the associated objects before and after it are in an "or" relationship.

In the present application, the same reference numerals denote the same components, and for the sake of brevity, detailed descriptions of the same components are omitted in different embodiments. It should be understood that the thickness, length, width and other dimensions of the various components in the embodiments of the present application shown in the drawings, as well as the overall thickness, length, width and other dimensions of an integrated apparatus, are for illustrative purposes only, and should not constitute any limitation to the present application.

Reference in the present application to an "embodiment" means that a particular feature, structure, or characteristic described in connection with the embodiment can be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described in the present application may be combined with other embodiments.

The battery refers to a single physical module including one or more battery cells to provide higher voltage and capacity. For example, in a power system, the battery may include a battery module or a battery pack. Generally, the battery further includes a box body for encapsulating the one or more battery cells. The box body can prevent liquid or other foreign matters from affecting charging or discharging of the battery cells. As another example, in an energy storage system, the battery may include a battery box, a battery cluster, an electrical cabinet, a container, or the like.

Optionally, the battery may be a lithium-ion battery, a lithium-metal battery, a lead-acid battery, a nickel-cadmium battery, a nickel-hydride battery, a lithium-sulfur battery, a lithium-air battery, a sodium-ion battery, a magnesium-ion battery, or the like. The present application does not impose a limitation on this.

In a case where a battery cell in the battery undergoes thermal runaway, the temperature inside the battery cell rises, which may trigger a chain reaction of thermal runaway, thereby causing fire, explosion, or the like of the battery. Meanwhile, it may cause the propagation of thermal runaway, thereby posing risks to other batteries arranged adjacent to the battery. Typically, it is necessary to trigger thermal runaway of a certain battery cell in the battery to test the propagation of thermal runaway within the battery when that battery cell undergoes thermal runaway, thereby analyzing the safety of the battery.

For example, a heating element may be arranged inside the battery cell, and the battery cell is heated by the heating element to trigger thermal runaway of the battery cell.

As another example, by connecting a positive terminal of a power source to a negative electrode of the battery cell, and electrically connecting a negative terminal of the power source to a case of the battery cell, copper deposition can be caused to occur inside the battery cell, which triggers an internal short circuit in the battery cell, causing the temperature of the battery cell to rise rapidly, thereby triggering thermal runaway of the battery cell.

However, methods such as triggering an internal short circuit of the battery cell, or arranging a heating element inside the battery cell, all require providing a special battery pack in advance, or require specific destruction and modification of the structure of the battery, making it difficult to simulate the propagation behavior of thermal runaway in the battery in practical applications.

For this purpose, the present application provides a triggering solution for thermal runaway in a battery, which involves charging a specific battery cell in the battery until its energy level is higher than the energy level of the other battery cells in the battery, and then charging the battery as a whole, such that before the other battery cells reach a charging cutoff voltage, the specific battery cell undergoes thermal runaway due to overcharging.

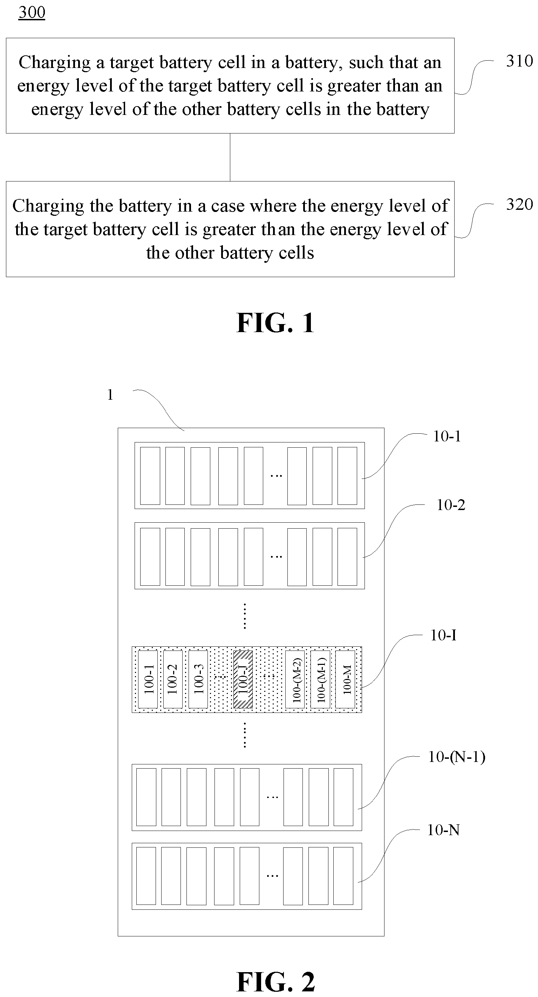

FIG. 1 illustrates a schematic flowchart of a method for triggering battery thermal runaway according to an embodiment of the present application. As shown in FIG. 1, the method 300 includes some or all of the following steps.

In step 310, a target battery cell in a battery is charged, such that an energy level of the target battery cell is greater than an energy level of the other battery cells in the battery.

In step 320, the battery is charged in a case where the energy level of the target battery cell is greater than the energy level of the other battery cells

The energy level mentioned here is used to indicate the amount of stored charge or energy, and may include, for example, State of Charge (SOC), State of Energy (SOE), or capacity, or the like. Herein, SOC may, for example, refer to a percentage of the remaining charge capacity, that is, a ratio of the remaining charge capacity to a rated capacity, and SOE may, for example, refer to a percentage of the remaining energy.

Taking SOC as an example, in step 310, the target battery cell in the battery is first charged until its SOC is greater than the SOC of the other battery cells, and then in step 320, the battery as a whole is charged until the SOC of the target battery cell becomes too large, causing overcharge and leading to an abnormality.

Here, the abnormality includes, for example, a situation where the target battery cell undergoes thermal runaway. Herein, during charging or use, if for various reasons the voltage and/or temperature of the target battery cell rises and cannot be effectively controlled, leading to safety issues such as overheating, combustion, fire, or explosion of the target battery cell, it can be considered that the target battery cell has undergone thermal runaway. Optionally, a thermal runaway condition may be set, and in a case where the target battery cell reaches the thermal runaway condition, it is determined that the target battery cell has undergone thermal runaway.

For example, for an energy storage battery, the thermal runaway condition may include: the voltage of the battery being greater than or equal to 1 V and a temperature rise rate of the battery over three consecutive samplings being greater than or equal to 3 °C/s, or state information of the battery including fire or explosion.

As another example, for a power battery, the thermal runaway condition may include: a) the battery producing a voltage drop, and the voltage drop of the battery exceeding 25% of an initial voltage; b) the temperature of the battery exceeding a temperature threshold, namely a specified maximum operating temperature; and c) a temperature rise rate of the battery being greater than or equal to 1 °C/s, for example, the temperature rise rate being greater than or equal to 1 °C/s and persisting for 3s or more. When a) and c) occur or b) and c) occur, it is determined that thermal runaway has occurred.

It can be understood that the target battery cell is a battery cell selected from the plurality of battery cells in the battery for triggering thermal runaway. The target battery cell may include one or more battery cells, so as to adapt to various testing requirements. Herein, in a case where the target battery cell includes a plurality of battery cells, the plurality of battery cells are connected in parallel and/or in series.

For example, the target battery cell may be one battery cell among the plurality of battery cells of the battery; as another example, the target battery cell may include several battery cells connected in series; as yet another example, the target battery cell may include several battery cells connected in parallel, for example, including one minimum parallel unit, or including a plurality of minimum parallel units connected in series.

The other battery cells refer to battery cells in the battery other than the target battery cell. Optionally, the energy level of the other battery cells may refer to an average energy level of the other battery cells, an energy level of a certain one of the other battery cells, or an energy level of a battery cell having a highest energy level among the other battery cells, or the like.

In the embodiments of the present application, the target battery cell is charged until its energy level is higher than the energy level of the other battery cells in the battery, by creating an energy level imbalance between the target battery cell and the other battery cells, during charging of the battery as a whole, before the other batteries reach a charging cutoff voltage, the target battery cell can undergo thermal runaway due to overcharging, while the other battery cells operate within a normal energy level range.

Compared to a solution for triggering thermal runaway by arranging a heating element inside a battery cell, or a solution for triggering thermal runaway by connecting a positive terminal of a power source to a negative electrode of a battery cell and electrically connecting a negative terminal of the power source to a case of the battery cell, adopting the method 300 in the embodiments of the present application to trigger occurrence of thermal runaway in the target battery cell due to overcharging has the following advantages:

Firstly, there is no need to prepare special battery cells or batteries during the production process, nor is there a need for complex modification of the battery, making the testing process unrestricted by time and space, and enabling widespread application in sampling tests of batteries;

secondly, the structure of the battery is not destroyed, reducing the impact on the airtightness and high-voltage electrical connection of the battery;

finally, the thermal runaway behavior during a dynamic charging process can be simulated.

The method 300 is applicable to various types of lithium-ion batteries, and the test results are stable and reliable.

In the embodiments of the present application, the battery to be tested may be a battery pack or a battery module in a power system, or may be a battery box, a battery cluster, an electrical cabinet, or a container in an energy storage system.

As an example, assuming that there is a need to simulate the propagation of thermal runaway between battery boxes, namely the impact of thermal runaway on adjacent battery boxes, as shown in FIG. 2, the battery to be tested may be a battery box. Taking the target battery cell including one battery cell as an example, the battery cluster 1 shown in FIG. 2 includes a plurality of battery boxes. For example, as shown in FIG. 2, the number of battery boxes in the battery cluster 1 is N, including a battery box 10-1, a battery box 10-2, ..., a battery box 10-I, ..., a battery box 10-(N-1), and a battery box 10-N, where I and N are positive integers and I is less than or equal to N. Herein, each battery box includes a plurality of battery cells connected in parallel and/or in series. For example, as shown in FIG. 2, the number of battery cells in each battery box is M, including a battery cell 100-1, a battery cell 100-2, a battery cell 100-3, ..., a battery cell 100-J, ..., a battery cell 100-(M-2), a battery cell 100-(M-1), and a battery cell 100-M, where J and M are positive integers and J is less than or equal to M.

Any one of battery boxes in the battery cluster 1 may be selected, and any one of battery cells in that battery box may be selected to serve as the target battery cell for triggering thermal runaway. For example, the battery box 10-I located at a central portion of the battery cluster 1 is selected, and the battery cell 100-J located at a central portion of the battery box 10-I is selected to serve as the target battery cell for triggering thermal runaway.

During the testing process, the battery cell 100-J needs to be charged until its energy level is higher than the energy level of the other battery cells in the battery, and the battery as a whole is charged, such that before the other battery cells reach a charging cutoff voltage, the battery cell 100-J undergoes thermal runaway due to overcharging.

In a case where the battery cell 100-J undergoes thermal runaway, the thermal runaway may propagation to other battery boxes adjacent to the battery box 10-I in which it is located. By observing the states of the other battery boxes arranged adjacent, the situation of propagation of the thermal runaway between the battery boxes can be judged. Hereinafter, the other battery boxes arranged adjacent to the battery box in which the target battery cell is located are referred to as monitoring objects.

Here, the central portion of the battery cluster 1 refers to a battery box located at or near a central position among the plurality of the battery boxes in the battery cluster 1, for example, the battery box 10-I located at the central portion of the battery cluster 1; referring to the battery box arrangement shown in FIG. 2, I may be, for example, N/2, (N-1)/2, or (N+1)/2. The central portion of the battery box 10-I refers to a battery cell located at a central position among the plurality of the battery cells in the battery box 10-I, for example, the battery cell 100-J at the central portion of the battery box 10-I; referring to the battery cell arrangement shown in FIG. 2, J may be, for example, M/2, (M-1)/2, or (M+1)/2.

In FIG. 2, the positional relationships between the battery cells shown and the positional relationships between the battery boxes are merely examples. In practical applications, the battery cells may be arranged within the box body of the battery box in other layout manners, and the battery boxes may also form a battery cluster in other layout manners.

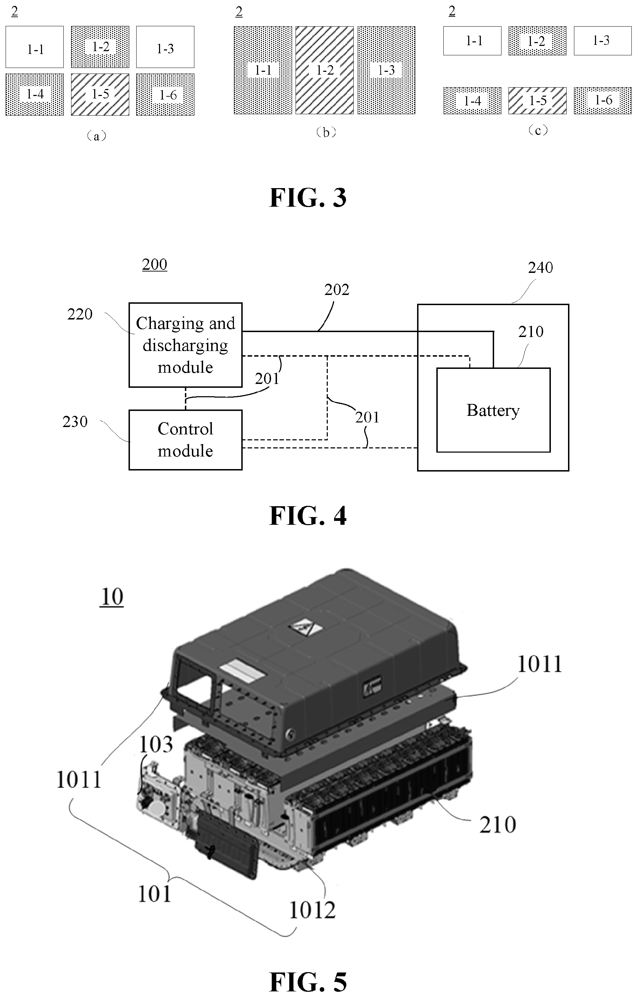

Similarly, assuming that there is a need to simulate the propagation of thermal runaway between battery clusters, namely the impact of thermal runaway on adjacent battery clusters, as shown in FIG. 3, the battery to be tested may be a battery cluster. Taking the target battery cell including one battery cell as an example, the electrical cabinet 2 shown in FIG. 3 includes a plurality of battery clusters.

For example, as shown in (a) of FIG. 3, the electrical cabinet 2 includes 6 battery clusters, namely a battery cluster 1-1, a battery cluster 1-2, a battery cluster 1-3, a battery cluster 1-4, a battery cluster 1-5, and a battery cluster 1-6; the 6 battery clusters are arranged in a dual-row arrangement, where the target battery cell is located in the battery cluster 1-5, for example, located in a battery box at a central portion of the battery cluster 1-5, and located at a central portion of the battery box.

During the testing process, the target battery cell in the battery cluster 1-5 needs to be charged until its energy level is higher than the energy level of the other battery cells in the battery cluster 1-5, and the battery cluster 1-5 as a whole is charged, such that before the other battery cells in the battery cluster 1-5 reach a charging cutoff voltage, thermal runaway occurs in the target battery cell in the battery cluster 1-5 due to overcharging.

Meanwhile, the battery cluster 1-2, the battery cluster 1-4, and the battery cluster 1-6 arranged adjacent to the battery cluster 1-5 are monitoring objects. By observing the states of the monitoring objects, the situation of propagation of the thermal runaway between the battery clusters can be judged.

As another example, as shown in (b) of FIG. 3, the electrical cabinet 2 includes 3 battery clusters, namely a battery cluster 1-1, a battery cluster 1-2, and a battery cluster 1-3; the 3 battery clusters are arranged in a single-row arrangement, where the target battery cell is located in the battery cluster 1-2, for example, located in a battery box at a central portion of the battery cluster 1-2, and located at a central portion of the battery box.

During the testing process, the target battery cell in the battery cluster 1-2 needs to be charged until its energy level is higher than the energy level of the other battery cells in the battery cluster 1-2, and the battery cluster 1-2 as a whole is charged, such that before the other battery cells in the battery cluster 1-2 reach a charging cutoff voltage, thermal runaway occurs in the target battery cell in the battery cluster 1-2 due to overcharging.

Meanwhile, the battery cluster 1-1 and the battery cluster 1-3 arranged adjacent to the battery cluster 1-2 are monitoring objects. By observing the states of the monitoring objects, the situation of propagation of the thermal runaway between the battery clusters can be judged.

For example, as shown in (c) of FIG. 3, the electrical cabinet 2 includes 6 battery clusters, namely a battery cluster 1-1, a battery cluster 1-2, a battery cluster 1-3, a battery cluster 1-4, a battery cluster 1-5, and a battery cluster 1-6; the 6 battery clusters are arranged in a channel arrangement, where the target battery cell is located in the battery cluster 1-5, for example, located in a battery box at a central portion of the battery cluster 1-5, and located at a central portion of the battery box.

During the testing process, the target battery cell in the battery cluster 1-5 needs to be charged until its energy level is higher than the energy level of the other battery cells in the battery cluster 1-5, and the battery cluster 1-5 as a whole is charged, such that before the other battery cells in the battery cluster 1-5 reach a charging cutoff voltage, thermal runaway occurs in the target battery cell in the battery cluster 1-5 due to overcharging.

Meanwhile, the battery cluster 1-2, the battery cluster 1-4, and the battery cluster 1-6 arranged adjacent to the battery cluster 1-5 are monitoring objects. By observing the states of the monitoring objects, the situation of propagation of the thermal runaway between the battery clusters can be judged.

In embodiments of the present application, selecting a battery box located at a central portion in the battery cluster, and/or selecting a battery cell at a central portion of the battery box as the target battery cell, can make the propagation of thermal runaway more uniform, thereby making the test results more comprehensive and stable.

The battery cluster in which the target battery cell is located, and the monitoring objects arranged adjacent to the battery cluster, are arranged in a simulated arrangement based on the actual installation situation inside a prefabricated cabin. The arrangement manner between the battery clusters shown in FIG. 3 is merely an example.

It can be understood that, in the embodiments of the present application, since it is necessary to investigate the impact of thermal runaway in a battery on other batteries adjacent to it, the monitoring objects arranged adjacent to the battery in which the target battery cell is located may be real batteries, or, they may not be real batteries but rather structures or apparatuses simulated to replace real batteries, for example, including only a part of the battery, such as the box body.

For example, as shown in FIG. 3, in (a) and (c) of FIG. 3, the battery cluster 1-5 is a real battery cluster, which includes the target battery cell, while the monitoring objects, namely the battery cluster 1-2, the battery cluster 1-4, and the battery cluster 1-6, may be real battery clusters identical to the battery cluster 1-5, or may be other structures or apparatuses used to replace the battery cluster 1-2, the battery cluster 1-4, and the battery cluster 1-6.

As another example, as shown in FIG. 3, in (b) of FIG. 3, the battery cluster 1-2 is a real battery cluster, which includes the target battery cell, while the monitoring objects, namely the battery cluster 1-1 and the battery cluster 1-3, may be real battery clusters identical to the battery cluster 1-2, or may be other structures or apparatuses used to replace the battery cluster 1-1 and the battery cluster 1-3.

In some embodiments, the method 300 may be executed by a system for triggering battery thermal runaway. As shown in FIG. 4, the system 200 includes a battery 210 to be tested, a charging and discharging module 220, and a control module 230. The battery 210 includes a plurality of battery cells.

The battery 210 may be a battery box, for example, the battery box 10-I shown in FIG. 1, or may be a battery cluster, for example, the battery cluster 1-5, the battery cluster 1-2, and the battery cluster 1-5 shown in (a), (b), and (c) of FIG. 3, respectively. Certainly, the battery 210 may also be any level of battery unit such as a battery pack, a battery module, an electrical cabinet, a container, or the like.

As an example, as shown in FIG. 4, any two of the battery 210, the charging and discharging module 220, and the control module 230 can communicate via a communication line 201, for example, for transmitting instructions and information. Optionally, the system 200 further includes a temperature chamber 240, the temperature chamber 240 being configured to keep a temperature of the battery 210 unchanged during the testing process, so as to reduce the impact of temperature changes on the test results. At this time, instructions and information may alternatively be transmitted between the control module 230 and the temperature chamber 240 via the communication line 201. A high-voltage connection line 202 is provided between the charging and discharging module 220 and the battery 210, and the charging and discharging module 220 may charge and/or discharge the battery 210 through the high-voltage connection line 202.

Optionally, the aforementioned method 300 may be executed by the control module 230. Specifically, the control module 230 is configured to control the charging and discharging module 220 to charge the target battery cell in the battery 210, such that an energy level of the target battery cell is greater than an energy level of the other battery cells in the battery 210, and to control the charging and discharging module 230 to charge the battery 210.

In some embodiments, the charging and discharging module 220 may include a first charging and discharging apparatus and a second charging and discharging apparatus, where the first charging and discharging apparatus is configured to charge and discharge the target battery cell in the battery 210, and the second charging and discharging apparatus is configured to charge and discharge the battery 210 as a whole. In other words, the control module 230 may control the first charging and discharging apparatus to charge and discharge the target battery cell, and control the second charging and discharging apparatus to charge and discharge the battery 210.

The first charging and discharging apparatus may be, for example, a charging and discharging machine with a relatively large range, such as a charging and discharging machine with a current between 50 A and 500 A and a voltage greater than 600 V, and the second charging and discharging apparatus may be, for example, a charging and discharging machine with a relatively small range, such as a charging and discharging machine with a current between 2 A and 10 A and a voltage less than 60 V.

Selecting the adapted first and second charging and discharging apparatuses respectively for the target battery cell and the battery 210, can effectively charge or discharge the target battery cell and the battery 210, respectively, thereby improving the charging and discharging performance.

Certainly, the same charging and discharging apparatus may alternatively be used to charge and discharge the battery 210 and the target battery cell, which is not limited in the present application.

A current used by the first charging and discharging apparatus to charge the target battery cell may be, for example, less than or equal to 5 A, and further, less than or equal to 2 A, thereby meeting the charging capability of most small-range charging and discharging machines.

The second charging and discharging apparatus and the battery 210 can perform information exchange with, for example, a battery management system of the battery 210, whereas the charging and discharging module 220 and the target battery cell may not perform information exchange, as long as information on the voltage and current of the battery can be collected. Optionally, the first charging and discharging apparatus possesses the following functions: controlling a switch of a charging and discharging circuit, regulating an output voltage and current, and monitoring information on the voltage, current, or the like of the battery.

When the control module 230 controls the charging and discharging module 220 to charge the target battery cell, the control module 230 may send a first charging and discharging instruction to the first charging and discharging apparatus, and the first charging and discharging apparatus, in response to the first charging and discharging instruction, charges or discharges the target battery cell; and when the control module 230 controls the charging and discharging module 220 to charge the battery 210, the control module 230 may send a second charging and discharging instruction to the second charging and discharging apparatus, and the second charging and discharging apparatus, in response to the second charging and discharging instruction, charges or discharges the battery 210.

A port of a lead of the second charging and discharging apparatus should match a design of a charging and discharging port of the battery 210, so as to achieve electrical connection between the second charging and discharging apparatus and the battery 210. A port of a lead of the first charging and discharging apparatus needs to be capable of achieving stable connection with an electrode terminal of a battery cell.

For example, in some embodiments, during charging and discharging of the target battery cell by the first charging and discharging apparatus, an end portion of a positive electrode lead of the first charging and discharging apparatus is adhered to a positive electrode terminal of the target battery cell, and an end portion of a negative electrode lead of the first charging and discharging apparatus is adhered to a negative electrode terminal of the target battery cell.

For example, conductive adhesive tape or conductive adhesive may be used to adhere the end portion of the positive electrode lead of the first charging and discharging apparatus to the positive electrode terminal of the target battery cell, and adhere the end portion of the negative electrode lead of the first charging and discharging apparatus to the negative electrode terminal of the target battery cell. This connection method can save costs.

Alternatively, in some other embodiments, during charging and discharging of the target battery cell by the first charging and discharging apparatus, an end portion of a positive electrode lead of the first charging and discharging apparatus is pressed into contact with a positive electrode terminal of the target battery cell by a push-pressing mechanism, and an end portion of a negative electrode lead of the first charging and discharging apparatus is pressed into contact with a negative electrode terminal of the target battery cell by the push-pressing mechanism.

Since the push-pressing mechanism is used to directly press the end portions of the leads and the electrode terminals of the target battery cell together, the reliability of contact between the leads and the electrode terminals is improved, thereby reducing the probability of poor contact occurring between the leads and the electrode terminals during the testing process.

Furthermore, other connection methods capable of forming a current loop between the target battery cell and the first charging and discharging apparatus and keeping the loop stable can also be applied in the testing process to connect the first charging and discharging apparatus and the target battery cell.

The control module 230 can be, for example, a monitoring computer. The monitoring computer may control the charging and discharging module 220 to execute charging and discharging functions, and the charging and discharging module 220 may alternatively transmit information on the voltage, current, or the like, that it has collected, to the monitoring computer, and the monitoring computer may display the information on the voltage, current, or the like of the target battery cell and the battery, as well as monitored information of other batteries arranged adjacent, to test personnel through its display interface.

The monitoring computer may also directly collect temperature information of the target battery cell and the battery, obtain a temperature rise rate, and present information on the temperature, the temperature rise rate, or the like to the test personnel through its display interface.

Optionally, a temperature of the target battery cell may be collected by a temperature sensor disposed on the target battery cell. For example, a temperature sensor on each battery cell in the target battery cell is located at a position on the battery cell closest to both the positive electrode terminal and the negative electrode terminal, and a distance between the temperature sensor and the positive electrode terminal is equal to a distance between the temperature sensor and the negative electrode terminal, thereby improving the stability and accuracy of the temperature collected by the temperature sensor. The temperature sensor may be, for example, a temperature sampling wire.

In some embodiments, as to the battery box 10 as shown in FIG. 5, the battery box 10 includes the battery 210 and a box body 101 configured to accommodate the battery 210, where the battery 210 includes a target battery cell, and the box body 101 includes a first box body portion 1011 and a second box body portion 1012 interlocked together, with electrode terminals of the battery cells in the battery 210 all facing the first box body portion 1011, where during charging of the target battery cell, the first box body portion 1011 is in a removed state, so as to enable connection between the electrode terminals and the first charging and discharging apparatus. That is, the first box body portion 1011 is removed from the second box body portion 1012 to expose the battery cells disposed inside the second box body portion 1012, without changing other structures within the battery 210.

Specifically, during the testing process, before step 310, it is necessary to remove the first box body portion 1011 to expose the electrode terminals of the plurality of battery cells inside the box body 101, and connect the conductive end portions of the first charging and discharging apparatus to the electrode terminals of the target battery cell. For example, an end portion of a positive electrode lead of the first charging and discharging apparatus is adhered to a positive electrode terminal of the target battery cell, and an end portion of a negative electrode lead of the first charging and discharging apparatus is adhered to a negative electrode terminal of the target battery cell; as another example, a push-pressing mechanism is controlled to press an end portion of a positive electrode lead of the first charging and discharging apparatus against a positive electrode terminal of the target battery cell, and the push-pressing mechanism is controlled to press an end portion of a negative electrode lead of the first charging and discharging apparatus against a negative electrode terminal of the target battery cell. It should be noted that, during this process, an electrical connector of the target battery cell should not be damaged, for example, by prying up a busbar component.

After the connection between the first charging and discharging apparatus and the target battery cell is completed, in step 310, the first charging and discharging apparatus is controlled to charge the target battery cell to enable its energy level to exceed the energy level of the other battery cells.

As demonstrated, since it is only necessary to open the first box body portion 1011 of the box body 101 and connect the leads of the first charging and discharging apparatus to the electrode terminals of the target battery cell, after the first charging and discharging apparatus completes charging the target battery cell, the connection between the target battery cell and the first charging and discharging apparatus can be disconnected, and the first box body portion 1011 can be re-covered onto the second box body portion 1012, such that the state of the battery is the same as its state in practical application. During this process, the structure of the battery 210 is not destroyed, and neither the airtightness of the battery 210 nor high-voltage connectors 103 is affected.

It can be understood that the charging and discharging apparatus in the embodiments of the present application may be used to charge and/or discharge the battery, and it may be an apparatus having only a charging function, or an apparatus having only a discharging function, or may alternatively be an apparatus having both a charging function and a discharging function.

The first box body portion 1101 shown in FIG. 5 is a hollow structure with an opening, the second box body portion 1102 is a flat-plate structure, and the two are interlocked together to form an accommodating space configured to accommodate battery cells. In other implementations, both the first box body portion 1101 and the second box body portion 1102 may alternatively be hollow structures with openings, or the first box body portion 1101 may be a flat-plate structure and the second box body portion 1102 may be a hollow structure with an opening.

In some embodiments, in step 320, the battery may be charged with constant-current charging or constant-power charging. For a power battery, constant-current charging may typically be adopted to charge it to reduce risks caused by charging; and for an energy storage battery, constant-power charging may typically be adopted to charge it to improve the charging efficiency. Therefore, in step 310, if the battery 210 is intended for application in a power system, constant-current charging may be performed on the battery. For example, a current used in the constant-current charging may be greater than or equal to 1 C, for example, may be 1 C, 2 C, 3 C, etc., or the current used in the constant-current charging may be equal to a maximum allowable current of the battery. If the battery is intended for application in an energy storage system, constant-power charging may be performed on the battery, thereby adapting to the application of the battery in different scenarios.

In step 310, if the target battery cell is charged until its energy level significantly exceeds the energy level of the other battery cells, it is easier to cause thermal runaway of the target battery cell when charging the battery as a whole in a subsequent step 320; whereas if the target battery cell is charged until its energy level only slightly exceeds the energy level of the other battery cells, it can reduce the risk of the target battery cell being overcharged prematurely during the step 310.

For this purpose, in some embodiments, in the step 310, the target battery cell may be charged such that its energy level exceeds the energy level of the other battery cells, and such that an energy level difference between the energy level of the target battery cell and the energy level of the other battery cells is within a suitable range. It may be for example a range greater than or equal to 15% of the energy level in the fully charged state and less than or equal to 70% of the energy level in the fully charged state. Further, it may be for example a range greater than or equal to 20% of the energy level in the fully charged state and less than or equal to 50% of the energy level in the fully charged state. This range may be applicable to most lithium iron phosphate (such as LiFePO4 (which may also be abbreviated as LFP)) chemical system batteries and ternary material (Ni-Co-Mn, NCM) chemical system batteries. As an example, the amount by which the energy level of the target battery cell exceeds the energy level of the other battery cells may be 20%, 30%, 40%, 50%, or 60% of the energy level in the fully charged state.

Taking SOC as an example, in step 310, the target battery cell may be charged until its SOC exceeds the SOC of the other battery cells by an amount of at least 20% and no more than 50%. Alternatively, the SOC of the target battery cell is 20% or 40% higher than the SOC of the other battery cells.

In this way, the risk of overcharging of the target battery cell can be reduced during charging the target battery cell, and the occurrence of thermal runaway in the target battery cell is facilitated during charging of the battery as a whole, thereby achieving effective testing of the battery.

In some embodiments, before step 310, namely before charging the target battery cell in the battery, the method 300 further includes: adjusting an energy level of the battery to a preset energy level, where the preset energy level is less than an energy level of the battery in a fully charged state. In this way, the consistency of initial states of the battery cells in the battery can be maintained. This preset energy level can serve as a standard state for the sample to be tested, which facilitates standardizing the testing process.

In such an initial state, it is sufficient to charge the target battery cell until it exceeds this preset energy level by a certain degree; for example, the target battery cell is charged until its SOC exceeds this preset energy level by 20% to 50% of the energy level in the fully charged state.

In some embodiments, the preset energy level may be set to be less than or equal to 85% of the energy level in the fully charged state; further, the preset energy level is less than or equal to 70% of the energy level in the fully charged state, thereby reducing the risk of overcharging of the target battery cell during charging the target battery cell in step 310. For example, the preset energy level may be set to 50%, 60%, 70%, or 80% of the energy level in the fully charged state.

Further, in some embodiments, before adjusting the energy level of the battery 210 to the preset energy level, the method 300 further includes: charging the battery to the fully charged state, for example, charging the battery to the fully charged state at a rated power, namely initialization charging. In other words, the battery can first be charged to the fully charged state and then discharged until its energy level is the preset energy level, so as to achieve adjustment of the energy level of the battery in the initial state. Certainly, the battery may not be fully charged, but rather the battery can be directly charged from an energy level of 0 or another value to the preset energy level.

The preset energy level and/or the energy level difference between the target battery cell and the other battery cells can be set such that when the target battery cell undergoes thermal runaway, the other battery cells are close to the fully charged state, thereby enhancing the testing effect.

Taking SOC as an example, assuming that the preset energy level is 50%, and the energy level difference between the target battery cell and the other battery cells is 40%. After adjusting the SOC of the battery to 50%, the target battery cell in the battery is charged until its SOC is 90%, namely an SOC exceeding this preset energy level by 40%. At this time, the difference between the SOC of the target battery cell and the SOC of the other battery cells in the battery is 40%. Typically, the target battery cell may undergo thermal runaway when its SOC reaches approximately 110% or approximately 120%. During charging the battery as a whole, when the target battery cell undergoes thermal runaway, the SOC of the other battery cells in the battery is approximately 80%, close to that in the fully charged state. In this way, changes in the state of the battery during the occurrence and propagation of thermal runaway are more pronounced and are therefore easier to monitor.

In some embodiments, before step 310, namely before charging the target battery cell in the battery, the method 300 further includes: disabling a balancing function of a battery management system of the battery.

The balancing function of the battery is to adjust a voltage difference between battery cells or a voltage difference between battery cell groups to be within a suitable range, thereby causing each battery cell to maintain a substantially identical state during use and reducing the risk of overcharging or overdischarging. Since the embodiments of the present application require triggering occurrence of thermal runaway in the target battery cell due to overcharging, disabling the balancing function of the battery management system can reduce the risk of inability to trigger occurrence of thermal runaway in the target battery cell due to an energy level difference between the target battery cell and the other battery cells being balanced, thereby reducing an impact of the balancing function on the testing process.

In some embodiments, before step 320, namely before charging the battery 210, the method 300 further includes: disabling an overvoltage protection function of the battery management system of the battery.

Since an excessively high voltage may cause damage to the battery, the overvoltage protection function of the battery can reduce the probability of occurrence of abnormal voltage or excessively high voltage during charging and discharging of the battery. For example, upon detecting that a voltage of the battery exceeds a rated voltage, a charging and discharging circuit can be cut off to prevent the voltage from continuing to rise. Since the embodiments of the present application require triggering occurrence of thermal runaway in the target battery cell due to overcharging, it is necessary to disable the overvoltage protection function, in order to reduce the risk of termination of the testing process due to the charging circuit being cut off before the target battery cell undergoes thermal runaway, thereby reducing the impact of the overvoltage protection function on the testing process.

By setting appropriate test termination conditions, the testing requirements can be met while avoiding unnecessary consumption caused by purposeless testing. For this purpose, in some embodiments, the method 300 further includes: terminating charging the battery in a case where at least one of the following conditions is satisfied: the battery satisfying a thermal runaway condition; a temperature of the battery reaching a temperature threshold; a charging time of the battery reaching a time threshold; or a voltage of the battery reaching a voltage threshold.

It can be understood that the thermal runaway condition may adopt the definition of thermal runaway in relevant standards, namely the thermal runaway trigger determination conditions in relevant battery standards. Adopting the thermal runaway conditions from relevant standards to determine whether thermal runaway occurs in the battery facilitates integration of the method 300 with the existing standards, and facilitates promoting adoption of the method 300.

For example, for an energy storage battery, the thermal runaway condition may include: the voltage of the battery being greater than or equal to 1 V and a temperature rise rate of the battery over three consecutive samplings being greater than or equal to 3 °C/s, or state information of the battery including fire or explosion.

As another example, for a power battery, the thermal runaway condition may include: a) the battery producing a voltage drop, and the voltage drop of the battery exceeding 25% of an initial voltage; b) the temperature of the battery exceeding a temperature threshold, namely a specified maximum operating temperature; and c) a temperature rise rate of the battery being greater than or equal to 1 °C/s, for example, the temperature rise rate being greater than or equal to 1 °C/s and persisting for 3s or more. When a) and c) occur or b) and c) occur, it is determined that thermal runaway has occurred.

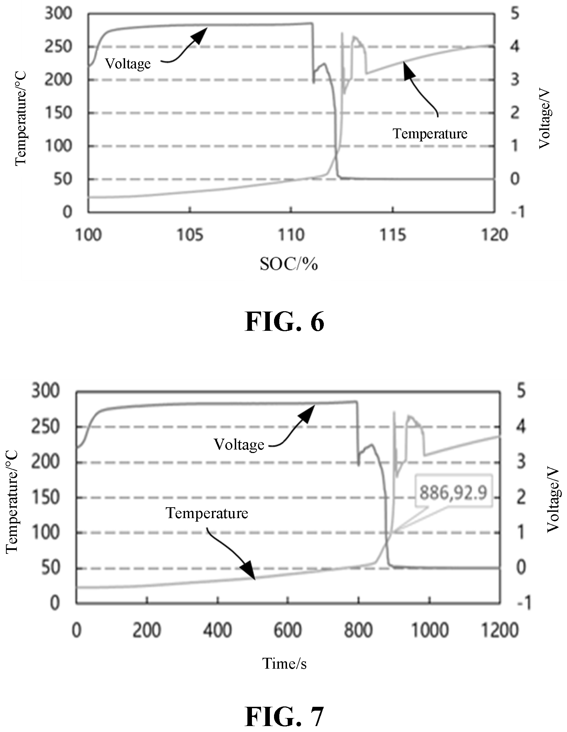

FIG. 6 and FIG. 7 show schematic diagrams illustrating voltage and temperature changes during thermal runaway. FIG. 6 and FIG. 7 take an LFP chemical system battery as an example, and use the voltage and the temperature rise rate as conditions. When charging the battery, if the voltage of the battery suddenly drops below 1 V, and three consecutive temperature rise rates are greater than or equal to 3 °C/s, it can be considered that thermal runaway has been triggered. As shown in FIG. 6, the SOC of the target battery cell is approximately 112% at this time, and as shown in FIG. 7, the charging time elapsed by this point is about 896 s. Meanwhile, this may also be accompanied by fire and/or explosion of the battery.

The time threshold may be set to, for example, greater than or equal to 4 hours; the temperature threshold may be set to, for example, greater than or equal to 300 °C; and the preset multiple may be set to, for example, greater than or equal to a predetermined multiple of a charging cutoff voltage of the battery, where the predetermined multiple may be, for example, between 1 and 1.2, such as equal to 1 times, 1.1 times, or 1.2 times. Here, for an LFP chemical system battery, 1.2 may be adopted, for example, whereas for a ternary chemical system battery, 1.1 may be adopted, for example.

If the battery does not meet the aforementioned thermal runaway condition, but the charging time reaches the time threshold, for example, 4 hours, the test can be terminated.

If the battery does not meet the aforementioned thermal runaway condition, but the temperature of the battery reaches the temperature threshold, for example, 300 °C, the test can be terminated.

If the battery does not meet the aforementioned thermal runaway condition, but the voltage of the battery reaches the preset multiple of the charging cutoff voltage, for example, 1.2 times, the test can be terminated.

By reasonably setting the thermal runaway condition, and setting test termination conditions such as charging time, battery temperature, and voltage, the testing process can be effectively controlled without affecting the test effects.

In some possible implementations, the method 300 further includes: monitoring, during charging of the battery, at least one of the following information of the battery and a monitoring object arranged adjacent to the battery 210: charging time, voltage, temperature, temperature rise rate, or state information. Here, the state information includes, for example, at least one of the following: swelling, electrolyte leakage, smoking, fire, explosion, and a position of box body rupture.

Based on the foregoing description, during charging of the battery, the charging time, voltage, current, temperature, and temperature rise rate of the battery are recorded; the voltage, current, temperature, and temperature rise rate of a monitoring object arranged adjacent to the battery are recorded; and test phenomena including swelling, electrolyte leakage, smoking, fire, explosion, a position of box body rupture, or the like, are recorded. By recording the aforementioned information of the battery during the charging process as well as the delay phenomena, whether thermal runaway of the battery is triggered can be timely determined.

When the target battery cell reaches the aforementioned thermal runaway conditions, for example, taking an energy storage battery as an example, the voltage of the battery is greater than or equal to 1 V and a temperature rise rate of the battery over three consecutive samplings is greater than or equal to 3 °C/s, or state information of the battery includes fire or explosion, or a temperature of the battery reaches a temperature threshold, or a charging time reaches a time threshold, or a voltage of the battery reaches a preset multiple of its charging cutoff voltage, then charging of the battery is terminated, followed by an observation performed for a certain duration, for example, greater than or equal to 8 hours. The charging time, and the voltage, temperature, and temperature rise rate of the battery are recorded, and test phenomena are recorded, including swelling, electrolyte leakage, smoking, fire, explosion, a position of box body rupture, or the like.

When judging whether thermal runaway has propagated to a monitoring object, namely whether thermal runaway has also occurred in the monitoring object, the aforementioned thermal runaway conditions can be adopted as the conditions for whether thermal runaway has also occurred in the monitoring object, for example: a voltage of the monitoring object is greater than or equal to 1 V and a temperature rise rate over three consecutive samplings is greater than or equal to 3 °C/s, or the monitoring object catches fire or explodes.

It can be understood that, after triggering thermal runaway in the target battery cell or after termination of the test, the battery itself and monitoring objects nearby may not necessarily exhibit obvious thermal runaway phenomena. For this purpose, in some embodiments, the method 300 further includes: testing insulation performance of the battery.

The insulation performance of the battery can reduce the risk of electrical leakage in the high-voltage circuit; when phenomena such as swelling, electrolyte leakage, smoking, fire, explosion, and box body rupture occur in the battery, the insulation performance of the battery is likely already compromised. However, after thermal runaway of the target battery cell is triggered or the test is terminated, and no obvious thermal runaway phenomenon is observed in the battery itself or its nearby monitoring, testing the insulation performance of the battery can provide a better understanding of the risks caused by battery thermal runaway, making the battery testing more comprehensive and reliable.

After the test is completed, it is necessary to disconnect the connection between the battery and the corresponding charging and discharging apparatus, remove the data sampling lines, and remove the battery.

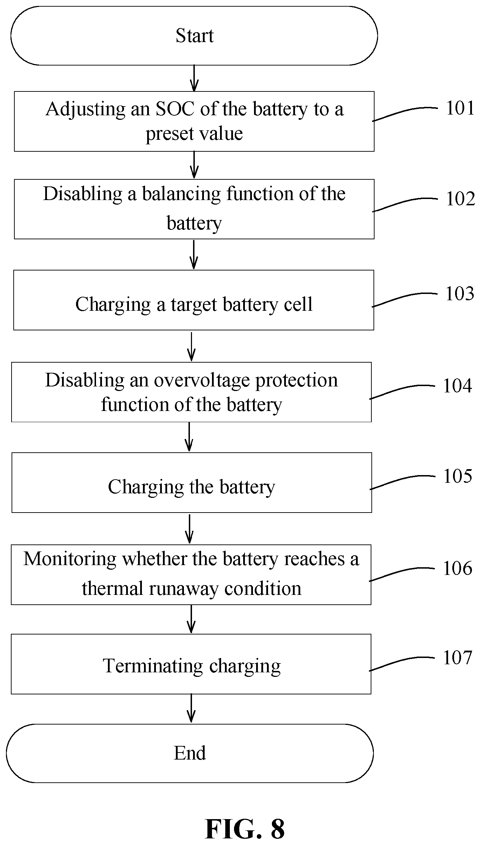

FIG. 8 is a schematic diagram of a possible specific testing process of the method 300. As shown in FIG. 8, the testing process includes some or all of the following steps.

In step 301, an SOC of the battery is adjusted to a preset energy level, for example, 50% SOC.

In step 302, a balancing function of the battery is disabled.

In step 303, a target battery cell in the battery is charged, such that an SOC of the target battery cell is higher than an energy level of the other battery cells in the battery. For example, the target battery cell is charged to 90% SOC.

Here, before charging the target battery cell, it is necessary to remove a first box body portion 1011 of a box body 101, and respectively connect an end portion of a positive electrode lead and an end portion of a negative electrode lead of a first charging and discharging apparatus to a positive electrode terminal and a negative electrode terminal of the target battery cell.

After charging of the target battery cell is completed, the first box body portion 1011 is covered onto a second box body portion 1012, such that the state of the battery is the same as its state in practical application.

In step 304, an overvoltage protection function of the battery is disabled.

In step 305, the battery as a whole is charged.

Furthermore, during the charging process, the charging time, voltage, current, temperature, and temperature rise rate of the battery are recorded; the voltage, current, temperature, and temperature rise rate of a monitoring object arranged adjacent to the battery are recorded; and test phenomena including swelling, electrolyte leakage, smoking, fire, explosion, a position of box body rupture, or the like, are recorded.

Here, before charging the battery, it is necessary to respectively connect an end portion of a positive electrode lead and an end portion of a negative electrode lead of a second charging and discharging apparatus to a positive electrode and a negative electrode of the battery.

In step 306, whether the battery reaches a thermal runaway condition is monitored.

In a case where the thermal runaway condition is reached, for example, a voltage of the battery suddenly drops below 1 V and three consecutive temperature rise rates are greater than or equal to 3 °C/s, or the battery catches fire or explodes, then step 307 is executed.

In addition, in a case where a test termination condition is satisfied, for example, a charging time reaches 4 hours, or a temperature of the battery reaches 300 °C, or a voltage of the battery reaches 1.2 times its charging cutoff voltage, step 307 is also executed.

In step 307, charging of the battery is terminated.

An observation is performed for 8 hours. A charging time, and a voltage, temperature, and temperature rise rate of the battery are recorded, and test phenomena are recorded, including swelling, electrolyte leakage, smoking, fire, explosion, a position of box body rupture, or the like.

The present application further provides a system for triggering battery thermal runaway. The system may be, for example, the system 200 shown in FIG. 4, and may include a battery 210, a charging and discharging module 220, and a control module 230. The battery 210 includes a target battery cell, where the control module 230 is configured to: control the charging and discharging module 220 to charge the target battery cell in the battery 210, such that an energy level of the target battery cell is greater than an energy level of the other battery cells in the battery; and control the charging and discharging module 230 to charge the battery in a case where the energy level of the target battery cell is greater than the energy level of the other battery cells.

In some embodiments, the charging and discharging module 220 includes a first charging and discharging apparatus and a second charging and discharging apparatus, where the first charging and discharging apparatus is configured to charge and discharge the target battery cell, and the second charging and discharging apparatus is configured to charge and discharge the battery 210.

In some embodiments, the target battery cell is accommodated within a box body, the box body including a first box body portion and a second box body portion interlocked together, with electrode terminals of the target battery cell facing the first box body portion, where during charging of the target battery cell by the first charging and discharging apparatus, the first box body portion is in a removed state, so as to enable connection between the electrode terminals and the first charging and discharging apparatus.

In some embodiments, an end portion of a positive electrode lead of the first charging and discharging apparatus is adhered to a positive electrode terminal of the target battery cell, and an end portion of a negative electrode lead of the first charging and discharging apparatus is adhered to a negative electrode terminal of the target battery cell.

In some embodiments, an end portion of a positive electrode lead of the first charging and discharging apparatus is pressed into contact with a positive electrode terminal of the target battery cell by a push-pressing mechanism, and an end portion of a negative electrode lead of the first charging and discharging apparatus is pressed into contact with a negative electrode terminal of the target battery cell by the push-pressing mechanism.

In some embodiments, the charging and discharging module 220 is further configured to: before charging the target battery cell in the battery 210, adjust an energy level of the battery 210 to a preset energy level, the preset energy level being less than an energy level of the battery 210 in a fully charged state. For example, the preset energy level is less than or equal to 85% of the energy level in the fully charged state. For example, the preset energy level is 50%, 60%, 70%, or 80% of the energy level in the fully charged state.

In some embodiments, the charging and discharging module 220 is specifically configured to: before adjusting the energy level of the battery 210 to the preset energy level, charge the battery 210 to the fully charged state; and discharge the energy level of the battery 210 from the energy level in the fully charged state to the preset energy level.

In some embodiments, the charging and discharging module 220 is specifically configured to: charge the target battery cell, such that the energy level of the target battery cell exceeds the energy level of the other battery cells by an amount greater than or equal to 15% of the energy level in the fully charged state, and less than or equal to 70% of the energy level in the fully charged state. For example, the amount by which the energy level of the target battery cell exceeds the energy level of the other battery cells is 20%, 30%, 40%, or 50% of the energy level in the fully charged state.

In some embodiments, the control module 230 is further configured to: before charging the target battery cell in the battery 210, disable a balancing function of a battery management system of the battery 210.

In some embodiments, the control module 230 is further configured to: before charging the battery 210, disable an overvoltage protection function of the battery management system of the battery 210.

In some embodiments, the control module 230 is further configured to control the charging and discharging module 220 to terminate charging the battery 210 in a case where at least one of the following conditions is satisfied: the battery 210 satisfying a thermal runaway condition; a temperature of the battery 210 reaching a temperature threshold; a charging time of the battery 210 reaching a time threshold; or a voltage of the battery 210 reaching a voltage threshold.

Here, the thermal runaway condition may include, for example: the voltage of the battery 210 being greater than or equal to 1 V and a temperature rise rate of the battery 210 over three consecutive samplings being greater than or equal to 3 °C/s, or state information of the battery 210 including fire or explosion.

Herein, the time threshold may be, for example, greater than or equal to 4 hours; the temperature threshold may be, for example, greater than or equal to 300 °C; and the voltage threshold is greater than or equal to 1.2 times a charging cutoff voltage of the battery 210.

In some embodiments, the target battery cell includes one or more battery cells, the plurality of battery cells being connected in parallel and/or in series.

In some embodiments, the battery 210 includes a battery box or a battery cluster.

In some embodiments, the battery 210 is a battery box, and the target battery cell is located at a central portion of the battery box.

In some embodiments, the battery 210 is a battery cluster, the battery cluster including a plurality of battery boxes, where a battery box in which the target battery cell is located among the plurality of battery boxes is located at a central portion of the battery cluster, the target battery cell being located at a central portion of the battery box in which it is located.

In some embodiments, the energy level includes any one of SOC, SOE, and capacity.

In some embodiments, the charging and discharging module 220 is specifically configured to perform constant-current charging or constant-power charging on the battery 210. Here, a current of the constant-current charging may be, for example, greater than or equal to 1 C, or may be a maximum allowable current of the battery 210.

In some embodiments, the control module 230 is further configured to monitor, during charging of the battery 210 by the charging and discharging module 220, at least one of the following information of the battery 210 and a monitoring object arranged adjacent to the battery 210: charging time, voltage, temperature, temperature rise rate, or state information. The state information includes, for example, at least one of the following: swelling, electrolyte leakage, smoking, fire, explosion, and a position of box body rupture.

In some embodiments, the system 200 further includes an insulation monitoring module, and the control module 230 is further configured to control the insulation monitoring module to test insulation performance of the battery 210.

It should be understood that the specific details of the system 200 may refer to the foregoing descriptions regarding the method 300, and for brevity, are not repeated here.

The present application further provides a testing device for a battery, including a processor, where the processor is configured to execute computer instructions stored in a memory to cause the testing device to implement content executed by the control module 230 in the method 300 described in at least some of the aforementioned embodiments. Optionally, the testing device may further include the memory, which is configured to store the computer instructions. The device may be, for example, an upper computer.

The present application further provides a computer-readable storage medium, which is configured to store a computer program, where the computer program, when executed by a computing device, causes the computing device to implement content executed by the control module 230 in the method 300 described in at least some of the aforementioned embodiments.

Those of ordinary skill in the art can realize that units and algorithm steps of each example described with reference to the examples disclosed herein can be implemented in electronic hardware, or a combination of computer software and electronic hardware. Whether these functions are performed in hardware or software depends on a specific application and a design constraint condition of the technical solution. Those skilled in the art can implement the described functions using different methods for each particular application, but such implementations should not be considered beyond the scope of the present application.

Those skilled in the art can clearly understand that, for the convenience and brevity of description, the specific working process of the system, apparatus, and unit described above may be obtained with reference to the corresponding process in the aforementioned method embodiments, which will not be repeated here.

In the several examples provided in the present application, it should be understood that the disclosed system, apparatus, and method may be implemented in other manners. The apparatus embodiments described above are only illustrative. For example, dividing of units is only a kind of logical function dividing, and there may be other dividing modes in actual implementation. For example, the plurality of units or components can be combined or integrated into another system, or some features can be ignored or not executed. On the other hand, the shown or discussed mutual coupling or direct coupling or communication connection may be indirect coupling or communication connection through some interfaces, apparatuses, or units, and may be in electrical, mechanical, or in other forms.

The units described as separate components may or may not be physically separated, and components displayed as units may or may not be physical units, that is, may be located in one place, or may be distributed to a plurality of network units. Some or all of the units may be selected according to actual needs to achieve the objectives of the solutions of the embodiments of the present application.

## Claims

1. A method for triggering battery thermal runaway, comprising:
charging a target battery cell in a battery, such that an energy level of the target battery cell is greater than an energy level of the other battery cells in the battery; and
charging the battery in a case where the energy level of the target battery cell is greater than the energy level of the other battery cells, so as to trigger thermal runaway of the battery.

2. The method according to claim 1, wherein before the charging the target battery cell in the battery, the method further comprises:
adjusting an energy level of the battery to a preset energy level, the preset energy level being less than an energy level of the battery in a fully charged state.

3. The method according to claim 2, wherein the preset energy level is less than or equal to 85% of the energy level in the fully charged state.

4. The method according to claim 3, wherein the preset energy level is 50%, 60%, 70%, or 80% of the energy level in the fully charged state.

5. The method according to any one of claims 2 to 4, wherein before the adjusting the energy level of the battery to the preset energy level, the method further comprises:
charging the battery to the fully charged state; and
wherein the adjusting the energy level of the battery to the preset energy level comprises:
discharging the energy level of the battery from the energy level in the fully charged state to the preset energy level.

6. The method according to any one of claims 1 to 5, wherein the charging the target battery cell in the battery, such that the energy level of the target battery cell is greater than the energy level of the other battery cells in the battery comprises:
charging the target battery cell, such that the energy level of the target battery cell exceeds the energy level of the other battery cells by an amount greater than or equal to 15% of the energy level in the fully charged state, and less than or equal to 70% of the energy level in the fully charged state.

7. The method according to claim 6, wherein the amount by which the energy level of the target battery cell exceeds the energy level of the other battery cells is 20%, 30%, 40%, or 50% of the energy level in the fully charged state.

8. The method according to any one of claims 1 to 7, wherein before the charging the target battery cell in the battery, the method further comprises:
disabling a balancing function of a battery management system of the battery.

9. The method according to any one of claims 1 to 8, wherein before the charging the battery, the method further comprises:
disabling an overvoltage protection function of the battery management system of the battery.

10. The method according to any one of claims 1 to 9, further comprising:
terminating charging the battery in a case where at least one of the following conditions is satisfied:
the battery satisfying a thermal runaway condition;
a temperature of the battery reaching a temperature threshold;
a charging time of the battery reaching a time threshold; or
a voltage of the battery reaching a voltage threshold.

11. The method according to claim 10, wherein the thermal runaway condition comprises:
the voltage of the battery being greater than or equal to 1 V and a temperature rise rate of the battery over three consecutive samplings being greater than or equal to 3 °C/s, or state information of the battery comprising fire or explosion; or
a voltage drop of the battery exceeding 25% of an initial voltage or the temperature of the battery exceeding the temperature threshold, and a temperature rise rate of the battery being greater than or equal to 1 °C/s.

12. The method according to claim 10 or 11, wherein
the time threshold is greater than or equal to 4 hours; and/or
the temperature threshold is greater than or equal to 300 °C; and/or
the voltage threshold is greater than or equal to 1.1 times or 1.2 times a charging cutoff voltage of the battery.

13. The method according to any one of claims 1 to 12, wherein the target battery cell comprises one or more battery cells, the plurality of battery cells being connected in parallel and/or in series.

14. The method according to any one of claims 1 to 13, wherein the battery is a battery box or a battery cluster.

15. The method according to claim 14, wherein the battery is a battery box, and the target battery cell is located at a central portion of the battery box.

16. The method according to claim 15, wherein the battery is a battery cluster, the battery cluster comprising a plurality of battery boxes, wherein a battery box in which the target battery cell is located among the plurality of battery boxes is located at a central portion of the battery cluster, the target battery cell being located at a central portion of the battery box in which it is located.

17. The method according to any one of claims 1 to 16, wherein the energy level comprises any one of State of Charge (SOC), State of Energy (SOE), or capacity.

18. The method according to any one of claims 1 to 17, wherein the charging the battery comprises:
performing constant-current charging or constant-power charging on the battery.

19. The method according to claim 18, wherein a current of the constant-current charging is greater than or equal to 1 C, or is a maximum allowable current of the battery.

20. The method according to any one of claims 1 to 19, further comprising:
monitoring, during charging of the battery, at least one of the following information of the battery and a monitoring object arranged adjacent to the battery:
charging time, voltage, temperature, temperature rise rate, or state information.

21. The method according to claim 20, wherein the state information comprises at least one of the following:
swelling, electrolyte leakage, smoking, fire, explosion, and a position of case rupture.

22. The method according to any one of claims 1 to 21, wherein the target battery cell is accommodated within a box body, the box body comprising a first box body portion and a second box body portion interlocked together, with electrode terminals of the target battery cell facing the first box body portion,
wherein during charging of the target battery cell, the first box body portion is in a removed state, so as to enable electrical connection between the electrode terminals and a charging and discharging apparatus; and
wherein the charging the target battery cell in the battery comprises:
controlling the charging and discharging apparatus to charge the target battery cell.

23. The method according to claim 22, wherein an end portion of a positive electrode lead of the charging and discharging apparatus is adhered to a positive electrode terminal of the target battery cell, and an end portion of a negative electrode lead of the charging and discharging apparatus is adhered to a negative electrode terminal of the target battery cell.

24. The method according to claim 22, wherein an end portion of a positive electrode lead of the charging and discharging apparatus is pressed into contact with a positive electrode terminal of the target battery cell by a push-pressing mechanism, and an end portion of a negative electrode lead of the charging and discharging apparatus is pressed into contact with a negative electrode terminal of the target battery cell by the push-pressing mechanism.

25. The method according to any one of claims 1 to 24, further comprising:
testing insulation performance of the battery.

26. A system for triggering battery thermal runaway, comprising:
a battery, the battery comprising a target battery cell;
a charging and discharging module; and
a control module configured to:
control the charging and discharging module to charge the target battery cell, such that an energy level of the target battery cell is greater than an energy level of the other battery cells in the battery; and
control the charging and discharging module to charge the battery in a case where the energy level of the target battery cell is greater than the energy level of the other battery cells.

27. The system according to claim 26, wherein the charging and discharging module comprises a first charging and discharging apparatus and a second charging and discharging apparatus, wherein the first charging and discharging apparatus is configured to charge and discharge the target battery cell, and the second charging and discharging apparatus is configured to charge and discharge the battery.

28. The system according claim 27, wherein the target battery cell is accommodated within a box body, the box body comprising a first box body portion and a second box body portion interlocked together, with electrode terminals of the target battery cell facing the first box body portion,
wherein during charging of the target battery cell by the first charging and discharging apparatus, the first box body portion is in a removed state, so as to enable connection between the electrode terminals and the first charging and discharging apparatus.

29. The system according to claim 28, wherein an end portion of a positive electrode lead of the first charging and discharging apparatus is adhered to a positive electrode terminal of the target battery cell, and an end portion of a negative electrode lead of the first charging and discharging apparatus is adhered to a negative electrode terminal of the target battery cell.

30. The system according to claim 28, wherein during charging and discharging of the target battery cell by the first charging and discharging apparatus, an end portion of a positive electrode lead of the first charging and discharging apparatus is pressed into contact with a positive electrode terminal of the target battery cell by a push-pressing mechanism, and an end portion of a negative electrode lead of the first charging and discharging apparatus is pressed into contact with a negative electrode terminal of the target battery cell by the push-pressing mechanism.

31. The system according to any one of claims 26 to 30, wherein the charging and discharging module is further configured to:
before charging the target battery cell in the battery, adjust an energy level of the battery to a preset energy level, the preset energy level being less than an energy level of the battery in a fully charged state.

32. The system according to claim 31, wherein the preset energy level is less than or equal to 85% of the energy level in the fully charged state.

33. The system according to claim 32, wherein the preset energy level is 50%, 60%, 70%, or 80% of the energy level in the fully charged state.

34. The system according to any one of claims 31 to 33, wherein the charging and discharging module is specifically configured to:
before adjusting the energy level of the battery to the preset energy level, charge the battery to the fully charged state; and
discharge the energy level of the battery from the energy level in the fully charged state to the preset energy level.

35. The system according to any one of claims 26 to 34, wherein the charging and discharging module is specifically configured to:
charge the target battery cell, such that the energy level of the target battery cell exceeds the energy level of the other battery cells by an amount greater than or equal to 15% of the energy level in the fully charged state, and less than or equal to 70% of the energy level in the fully charged state.

36. The system according to claim 35, wherein the amount by which the energy level of the target battery cell exceeds the energy level of the other battery cells is 20%, 30%, 40%, or 50% of the energy level in the fully charged state.

37. The system according to any one of claims 26 to 36, wherein the control module is further configured to:
before charging the target battery cell in the battery, disable a balancing function of a battery management system of the battery.

38. The system according to any one of claims 26 to 37, wherein the control module is further configured to:
before charging the battery, disable an overvoltage protection function of the battery management system of the battery.

39. The system according to any one of claims 26 to 38, wherein the control module is further configured to control the charging and discharging module to terminate charging the battery in a case where at least one of the following conditions is satisfied:
the battery satisfying a thermal runaway condition;
a temperature of the battery reaching a temperature threshold;
a charging time of the battery reaching a time threshold; or
a voltage of the battery reaching a voltage threshold.

40. The system according to claim 39, wherein the thermal runaway condition comprises:
the voltage of the battery being greater than or equal to 1 V and a temperature rise rate of the battery over three consecutive samplings being greater than or equal to 3 °C/s, or state information of the battery comprising fire or explosion; or
a voltage drop of the battery exceeding 25% of an initial voltage or the temperature of the battery exceeding the temperature threshold, and a temperature rise rate of the battery being greater than or equal to 1 °C/s.

41. The system according to claim 39 or 40, wherein the time threshold is greater than or equal to 4 hours, and/or the temperature threshold is greater than or equal to 300 °C, and/or the voltage threshold is greater than or equal to 1.1 times or 1.2 times a charging cutoff voltage of the battery.

42. The system according to any one of claims 26 to 41, wherein the target battery cell comprises one or more battery cells, the plurality of battery cells being connected in parallel and/or in series.

43. The system according to any one of claims 26 to 42, wherein the battery comprises a battery box or a battery cluster.

44. The system according to claim 43, wherein the battery is a battery box, and the target battery cell is located at a central portion of the battery box.

45. The system according to claim 44, wherein the battery is a battery cluster, the battery cluster comprising a plurality of battery boxes, wherein a battery box in which the target battery cell is located among the plurality of battery boxes is located at a central portion of the battery cluster, the target battery cell being located at a central portion of the battery box in which it is located.

46. The system according to any one of claims 26 to 45, wherein the energy level comprises any one of State of Charge (SOC), State of Energy (SOE), or capacity.

47. The system according to any one of claims 26 to 46, wherein the charging and discharging module is specifically configured to:
perform constant-current charging or constant-power charging on the battery.

48. The system according to claim 47, wherein a current of the constant-current charging is greater than or equal to 1 C, or is a maximum allowable current of the battery.

49. The system according to any one of claims 26 to 48, wherein the control module is further configured to:
monitor, during charging of the battery by the charging and discharging module, at least one of the following information of the battery and a monitoring object arranged adjacent to the battery:
charging time, voltage, temperature, temperature rise rate, or state information.

50. The system according to claim 49, wherein the state information comprises at least one of the following:
swelling, electrolyte leakage, smoking, fire, explosion, and a position of box body rupture.

51. The system according to any one of claims 26 to 50, wherein the system further comprises an insulation monitoring module, and the control module is further configured to:
control the insulation monitoring module to test insulation performance of the battery.
